# EUROPÄISCHE PATENTSCHRIFT

(11) **EP 0 461 525 B1**
(45) Veröffentlichungstag und Bekanntmachung des Hinweises auf die Patenterteilung: **28.12.1994**
(21) Anmeldenummer: 91109121.3
(22) Anmeldetag: 04.06.1991
(51) Int. Cl.: H01J 37/34

(54) **Verfahren und Vorrichtung zum Beschichten von Substraten mittels einer Magnetronkatode**
Method and device for substrate coating using a magnetron cathode
Procédé et dispositif pour revêtement d'un substrat utilisant une cathode-magnétron

(30) Priorität: 13.06.1990 DE 4018914
(43) Veröffentlichungstag der Anmeldung: 18.12.1991
(73) Patentinhaber: LEYBOLD AKTIENGESELLSCHAFT, D-63450 Hanau (DE)
(72) Erfinder: Beisswenger, Siegfried, Dr., W-8755 Alzenau (DE); Kukla, Reiner, Dipl.-Phys., W-6450 Hanau am Main 9 (DE); Fritsche, Wolf-Eckart, Dipl.-Ing., W-8752 Kleinostheim (DE); Lübbehusen, Michael, Dr.-Phys., W-6454 Bruchköbel (DE)

(56) Entgegenhaltungen:
- DE-A- 3 411 536
- DE-A- 3 727 901
- US-A- 3 956 093
- US-A- 4 604 180
- VACUUM Bd. 40, Nr. 3, März 1990, GREAT BRITAIN Seiten 251 - 255; H.BIEDERMAN ET AL: 'Hard Carbon and composite meta/hard carbon films prepared by a dc unbalanced planar magnetron '

## Beschreibung

Die Erfindung betrifft ein Verfahren zum Beschichten von Substraten durch Kathodenzerstäubung unter Verwendung einer Magnetronkathode mit einem ringförmig geschlossenen Target mit einer Zerstäubungsfläche, einem Innenrand und einem Außenrand und mit einem Permanentmagnete enthaltenden Magnetsystem, dessen einer, dem Target geometrisch ähnlicher, Pol außerhalb des Außenrandes und dessen anderer geometrisch ähnlicher und gleichfalls ringförmig geschlossener Pol innerhalb des Innenrandes angeordnet ist, derart, daß zumindest der überwiegende Teil der magnetischen Feldlinien auf nur wenig gekrümmten Bahnen in der Weise über die Zerstäubungsfläche hinweggeführt wird, daß ein ringförmiger, über der Zerstäubungsfläche geschlossener magnetischer Tunnel gebildet wird, wobei sich das Magnetsystem sowohl gegenüber Erdpotential als auch gegenüber Kathodenpotential auf einem sich selbst einstellenden elektrischen Potential befindet.

Bei einer klassischen Magnetronkathode, wie sie durch den Aufsatz von John S. Chapin "The Planar Magnetron", veröffentlicht in Research/Development, Januar 1974, beschrieben ist, liegen die Polflächen des Magnet-Systems hinter dem Target, und sie verlaufen parallel zur Zerstäubungsfläche, zumindest im Urzustand des Targets. Außerdem sind die Polabstände verhältnismäßig gering. Diese Bauweise des Magnetrons führt zu verhältnismäßig stark gekrümmten magnetischen Feldlinien, die aus der Zerstäubungsfläche austreten und nachdem Durchlaufen bogenförmiger Bahnen wieder in das Target eintreten. Die Folge ist ein verhältnismäßig schmaler und tiefer Erosionsgraben, der nur eine geringe Materialausnutzung des Targetmaterials erlaubt, da das Target rechtzeitig vor dem "Durchsputtern" ausgewechselt werden muß.

Durch die DE-A-22 43 708 ist es auch bereits bekannt, den Targetverbrauch dadurch zu vergleichmäßigen, daß man Zylinder- oder Kegelspulen vorsieht, deren Achsen koaxial zu den Achsen entsprechend geformter rotationssymmetrischer Targets angeordnet sind. Die Vorteile einer solchen Anordnung wirken sich jedoch nur bei den dort beschriebenen Hohlkathoden und Pfostenkathoden aus. Soweit planare Kathodenanordnungen beschrieben sind, entsteht durch die starke Krümmung der Magnetfeldlinien wieder der unerwünschte, lokal begrenzte und tiefe Erosionsgraben.

Man hat auch bereits versucht, den Erosionsgraben zu verbreitern und den Ausnutzungsgrad des Targets, den sogenannten Materialwirkungsgrad, dadurch zu erhöhen, daß man dem statischen Magnetfeld der Permanent-Magneten ein oszillierendes Magnetfeld eines Elektromagneten überlagert, so daß der rennbahnförmig verlaufende, geschlossene magnetische Tunnel periodisch auf der Targetoberfläche verschoben wird. Dieser periodischen Verschiebung folgt auch das in dem magnetischen Tunnel eingeschlossene Plasma, woraus sich die Verbreiterung des Erosionsgrabens ergibt (DE-C-25 56 607 = US-A-3956093). Infolge der sehr starken Krümmung der Feldlinien der Permanent-Magneten (die Krümmung entspricht in etwa derjenigen, die in dem Aufsatz von Chapin beschrieben ist) bedarf es jedoch außerordentlich hoher Feldstärken der Magnetspule, um überhaupt eine merkliche Verschiebung des überlagerten Magnetfeldes herbeiführen zu können. Durch die laufende Polungsumkehr des Elektromagneten wird im übrigen das überlagerte Magnetfeld nur ausgehend von einer Mittenlage verschoben, wobei diese Mittenlage durch den Verlauf der statischen Magnetfeldlinien der Permanentmagnete vorgegeben wird. Die Folge ist eine erhebliche Stromaufnahme der Magnetspule, die wiederum zu Kühlproblemen führt.

Durch die DE-A-27 29 286 ist es auch bereits bekannt, ein permanentes Magnetfeld mechanisch zu verlagern, was jedoch einen erheblichen technischen Aufwand bedingt.

Man ist daher auch bereits einen anderen Weg gegangen, der zu dem eingangs beschriebenen Verfahren geführt hat. Eine entsprechende Magnetronkathode, die auch den Oberbegriff des Patentanspruchs 1 bildet, ist durch die DE-C-34 11 536 bekannt. Bei dieser Magnetronkathode dient nur der wesentlich schwächer gekrümmte Anteil der Magnetfeldlinien dazu, das Plasma auf die Oberfläche der Kathode zu konzentrieren. Dies wird dadurch erreicht, daß die Pole des Magnetsystems den Targetquerschnitt auf beiden Seiten umgreifen, d. h. das Target ist ringförmig ausgebildet und hat in seiner Mitte eine Öffnung, in der der zentrale Pol des Magnetsystems angeordnet ist. Auf diese Weise ist es auch ohne die zusätzliche Anwendung eines oszillierenden Magnetfeldes möglich, die Targetabtragung zu vergleichmäßigen, jedoch ist diese Vergleichmäßigung noch nicht ausreichend, insbesondere dann nicht, wenn die Targetplatten eine größere Dicke haben, also beispielsweise mehr als 15 mm.

Sämtlichen bisher beschriebenen Magnetronkathoden ist gemeinsam, daß das die Zerstäubung bewirkende Plasma mehr oder weniger stark auf die unmittelbare Nähe der Targetoberfläche, der sogenannten Zerstäubungsfläche, konzentriert wird. Eine Ausdehnung des Plasmas in Richtung auf die Substrate, die für einige Beschichtungsprozesse wünschenswert ist, insbesondere für den Prozeß der reaktiven Kathodenzerstäubung, ist mit den bekannten Lösungen nicht möglich, und zwar weder mit noch ohne die Verwendung oszillierender Magnetfelder.

Nun ist es aber andererseits auch bereits bekannt, das Plasma dadurch weiter in Richtung auf die Substrate auszudehnen, daß man die bekannte Magnetronkathode gezielt "verstimmt" und beispielweise den von den äußeren Magnetpolen ausgehenden Feldlinien einen längeren Weg aufzwingt, der bis zu den Substraten reicht. Eine solche Maßnahme wird von Window und Savvides in dem Aufsatz "Charged particle fluxes from planar magnetron sputtering sources", veröffentlicht in J. Vac. Sci. Technol. A 4 (2), März/April 1986, beschrieben. Nicht gelöst ist dabei jedoch wiederum das Problem einer Vergleichmäßigung des Targetabtrags.

Man bezeichnet derartige verstimmte bzw. unbalancierte Magnetrons auch als "unbalanced magnetrons". Diesbezüglich wird auf den Aufsatz von Biederman u. a. "Hard carbon and composite metal/hard carbon films prepared by a dc unbalanced planar magnetron" (veröffentlicht in "Vacuum", Band 40, Nr. 3, 1990, Seiten 251 bis 255) verwiesen.

Verwendet man die vorstehend beschriebenen und bekannten Magnetronkathoden zum reaktiven Kathodenzerstäuben, d. h. zum Aufbringen chemischer Verbindungen, in denen das Targetmaterial (in der Regel ein Metall) nur eine Komponente darstellt, so ergeben sich weitere Probleme: Als eigentliches Sputtergas wird in der Regel ein Edelgas, vornehmlich Argon, verwendet. Diesem Edelgas wird ein entsprechendes Reaktivgas zugesetzt, bei der Herstellung von Oxiden Sauerstoff, bei der Herstellung von Nitriden Stickstoff, bei der Herstellung von Karbiden ein Kohlenwasserstoffgas etc. Die entsprechenden Reaktionsprodukte sind im allgemeinen elektrische Nichtleiter, die sich teilweise auch auf der Targetoberfläche ausbilden, was in der Praxis nicht oder jedenfalls nicht vollständig zu vermeiden ist. Lediglich im Bereich des Erosionsgrabens wird das Material schneller abgestäubt, als sich Reaktionsprodukte bilden können. In den übrigen Oberflächenbereichen können sich jedoch elektrische Aufladungen bilden, die schließlich zu Spannungsüberschlägen führen und einen instabilen Zerstäubungsprozeß zur Folge haben, und zwar nicht zuletzt deswegen, weil die geregelt Stromversorgung der Zerstäubungskathoden naturgemäß auf diese Spannungsüberschläge anspricht.

Der Erfindung liegt daher die Aufgabe zugrunde, einen guten Materialwirkungsgrad bzw. eine lange Standzeit des Targets zu erreichen, eine hohe Plasmadichte am Substrat bzw. im gesamten Raum zwischen Target und Substrat herbeizuführen und dabei dennoch eine hohe Sputterrate im Bereich üblicher Werte des klassischen Magnetrons zu erreichen.

Bei reaktiven Kathodenzerstäubungsverfahren soll die weitere Aufgabe gelöst werden, schädliche Ablagerungen von Nichtleitern auf der Zerstäubungsfläche und damit elektrische Überschläge zu vermeiden.

Die Lösung der gestellten Aufgabe erfolgt bei dem eingangs beschriebenen Verfahren erfindungsgemäß dadurch, daß
a) derjenige Bereich des magnetischen Tunnels, in dem die Feldlinien wenigstens angenähert parallel zur Zerstäubungsfläche verlaufen, wie sie im Neuzustand des Targets vorliegt, durch entsprechende Auslegung des Permanentmagnetsystems in die Nähe des äußeren Targetrandes verlagert wird, wodurch in Abwesenheit weiterer Magnetfelder die ringförmige Zone maximaler Targeterosion in die Nähe des äußeren Targetrandes verlagert wird,
b) außerhalb des äußeren Pols mittels einer ringförmig geschlossenen, dem Pol geometrisch ähnlichen und den Pol umgebenden Magnetspule ein sich zeitlich veränderndes weiteres Magnetfeld erzeugt wird, wobei durch mindestens einen von Null verschiedenen zeitlichen Mittelwert eines Erregerstroms ein Magnetfeld ausgebildet wird, durch das aufgrund der Polungsrichtung und der Überlagerung mit dem Magnetfeld des Permanentmagnetsystems die ringförmige Zone maximaler Targeterosion im wesentlichen in die Mitte zwischen den beiden Targeträndern verlagert wird, und daß
c) durch periodische Veränderung des Erregerstroms die Zone maximaler Targeterosion periodisch aus der Mittellage nach beiden Seiten verlagert wird.

Zunächst sei klargestellt, daß der Begriff "ringförmig" in bezug auf eine Draufsicht auf das Target, auf die Magnetpole sowie auf den magnetischen Tunnel bzw. (beim Betrieb) das Plasma nicht nur "kreisringförmig" bedeutet, sondern auch die geometrischen Formen des Ovals, der Rennbahn und des Rechtecks einschließt. Für die Beschichtung großflächiger Substrate wie beispielsweise von Fensterscheiben mit den Abmessungen 3 x 4 m² werden sogenannte Rechteckkathoden benötigt, bei denen zwei geradlinig und parallel zueinander verlaufende Targetabschnitte eine Länge von etwa 3,50 m haben und an ihren beiden Enden durch Targetabschnitte miteinander verbunden sind, die man sich durch die Halbierung eines kreisringförmigen Targets mit einem Außendurchmesser von ca. 30 cm entstanden denken kann. Diese unterschiedlichen Kathodenbauarten sind in der DE-A-35 27 628 ausführlich beschrieben.

Auch die Aussage, daß die magnetischen Pole den jeweils benachbarten Targeträndern "geometrisch ähnlich" sein sollen, besagt, daß die Pole den Rändern der beschriebenen Targetkonfigurationen in gleichem Abstand folgen. Bei größeren Targetlängen und/oder am Außenumfang kreisringförmiger Targets werden dabei in der Regel auf dem Umfang geschlossene Reihen von Permanentmagneten mit jeweils gleicher Pollage angeordnet. Dadurch, daß die entgegengesetzten Pole in an sich bekannter Weise den Targetquerschnitt umgreifen, wird nur derjenige Teil des magnetischen Feldes für die Formung des Plasmas verwendet, der einen verhältnismäßig schwach gekrümmten oder nahezu geradlinigen Verlauf aufweist. Da die Zerstäubungsrate dort am größten ist, wo die elektrischen und die magnetischen Feldlinien sich rechtwinklig kreuzen, ergibt sich aus dem flachen Verlauf der Magnetfeldlinien folgendes:

Die elektrischen Feldlinien verlaufen im allgemeinen in senkrechter Richtung zur ursprünglichen Targetoberfläche. Durch die schwache Krümmung der magnetischen Feldlinien ist die Zone, in der sich die besagten Feldlinien nahezu rechtwinklig kreuzen, deutlich breiter als bei dem klassischen Magnetron mit den stark gekrümmten Feldlinien. Daraus ergibt sich, daß auch der sogenannte Erosionsgraben mit wachsender Geradlinigkeit der magnetischen Feldlinien in der Breite deutlich zunimmt. Dies ist - obwohl bekannt - eine der wesentlichen Voraussetzungen für das erfindungsgemäße Verfahren.

Der sehr flache bzw. nahezu geradlinige Verlauf der wirksamen magnetischen Feldlinien ist auch von dem Vorteil begleitet, daß man zur Verschiebung der Kulminationspunkte dieser Feldlinien (bezogen auf die Targetoberfläche) nur sehr viel geringere Feldstärken seitens der Magnetspule benötigt, was einen deutlichen Vorteil gegenüber der Lösung nach der DE-PS 25 56 607 darstellt.

Die übrigen wesentlichen Merkmale des Erfindungsgegenstandes lassen sich wie folgt hervorheben:

Die Verstimmung des Permanentmagnetsystems gemäß Merkmal a) hat zunächst einmal den Vorteil, daß man der Magnetronkathode dadurch die Eigenschaften eines "unbalanced magnetron" verleiht. Würde man allerdings die Magnetron-Kathode ohne Einschaltung der Magnetspule mit ihrer speziellen Stromversorgung betreiben, so würde der Erosionsgraben - obwohl durch den flachen Verlauf der Magnetfeldlinien bereits erheblich verbreitert - in der Nähe des äußeren Targetrandes verlaufen.

Durch das Merkmal b) wird nun erreicht, daß mittels eines relativ schwachen, von einem Elektromagneten erzeugten Magnetfeldes eine Verschiebung der Zone maximaler Targeterosion in die Mitte zwischen den beiden Targeträndern verlagert wird (bezogen auf einen Querschnitt durch eine Seite des Targets). Dies bedeutet, daß der Erregerstrom ständig von Null verschieden ist, ohne jedoch besonders hohe Werte erreichen zu müssen, die die Charakteristik des "unbalanced magnetron" wieder in Frage stellen würde.

Das Merkmal c) beschreibt im wesentlichen die Maßnahme, den von Null verschiedenen zeitlichen Mittelwert des Erregerstroms periodisch zu verändern, und zwar gegebenenfalls auch auf den Wert Null, wodurch die Zone maximaler Targeterosion wieder in einen Bereich gelangt, in dem diese Zone sich allein aufgrund des Vorhandenseins des Permanentmagnetsystems befinden würde. Andererseits wird durch Erhöhung des Erregerstromes über den besagten zeitlichen Mittelwert hinaus die Zone maximaler Targeterosion in die Nähe des Innenrandes des Targets verschoben, und es versteht sich, daß durch ständige Veränderung des Erregerstroms um den von Null verschiedenen Mittelwert eine ständige Verlagerung der Erosionszone bewirkt wird.

Hiermit sind folgende Vorteile verbunden:

Es wird ein guter Materialwirkungsgrad bzw. eine lange Standzeit des Targets erreicht, desgleichen eine hohe Sputterrate, die den bei den klassischen Magnetron-Kathoden erzielbaren Werten entspricht. Durch die Erhaltung der Charakteristik des "unbalanced magnetron" wird eine hohe Plasmadichte auch am Substrat bzw. im gesamten Raum zwischen Target und Substrat erreicht, mithin günstige Voraussetzungen für einen optimalen Beschichtungsvorgang.

Hierbei ist zu beachten, daß die einzelnen Teilaufgaben im Grunde zu diametral entgegengesetzten Lösungen führen müßten. Es ist das Verdienst der Erfinder, hier einen Weg aufgezeigt zu haben, durch den sämtliche Forderungen in optimaler Weise miteinander vereint werden können.

Bei einem reaktiven Zerstäubungsprozeß werden zusätzlich die Vorteile erreicht, daß man mit einem geringeren Fluß an Reaktivgas, bezogen auf die Sputterrate, auskommt und gleichzeitig die gesamte Substratoberfläche praktisch vollkommen frei von isolierenden Belägen halten kann, so daß auch die gefürchteten Spannungsüberschläge vermieden werden.

Man kann sich das Magnetfeld an jeder einzelnen Stelle vor der Kathodenoberfläche in eine zur Kathodenoberfläche parallele und eine zur Kathodenoberfläche senkrechte Komponente zerlegt denken. Der Wert oder die Stärke dieser beiden Komponenten in einem Punkt ergibt sich aus einer additiven Superposition der jeweiligen Komponenten der Permanentmagnete und der elektromagnetischen Spule. Das Plasma ist dort am intensivsten, wo die Vertikalkomponente des Summenfeldes verschwindet oder einen sehr kleinen Wert besitzt. Hier bildet sich auf der Kathodenoberfläche der sogenannte Erosionsgraben aus. Durch die Magnetspule wird ein magnetisches Feld ausgebildet, das vor der Kathodenoberfläche vorrangig aus zur Kathodenfläche senkrechten Komponenten besteht. Deswegen besteht der Beitrag der Magnetspule zum Summenfeld vor der Kathodenoberfläche lediglich aus der Senkrechtkomponente; die zur Kathodenoberfläche waagrechte Komponente des Summenfeldes entspricht im wesentlichen der entsprechenden Komponente des Permanentmagnetfeldes. Durch die periodische Änderung des Erregerstromes der Magnetspule wird nun der Ort, wo die senkrechte Komponente des Summenfeldes vor der Kathodenoberfläche veschwindet bzw. einen sehr kleinen Wert besitzt, auf der Kathodenoberfläche von innen nach außen bzw. in umgekehrter Richtung verschoben. Auf diese Weise wird der Erosionsgraben auf der Targetoberfläche verschoben. Wesentlich hierbei ist, daß diese Verschiebung nicht durch einen zur 0-Linie symmetrischen Wechselstrom hervorgerufen wird, sondern daß die Wechselstromkomponente einem konstanten Gleichstromwert überlagert ist. Der Effekt des unbalanced Magnetron wird dabei in der Hauptsache durch den Gleichstromanteil der Magnetspule erreicht. Der überlagerte Wechselstromanteil führt solange nicht zu einer Schwächung des "unbalanced Effekts", solange die Strompolarität nicht umpolt.

Vergleichsversuche mit herkömmlichen Kathoden und einer statisch erregten Magnetspule für den Effekt des "unbalanced magnetron" haben gezeigt, daß zwar die Plasmadichte in Substratnähe erhöht werden konnte, daß aber aufgrund des Effekts des "unbalanced magnetron" das Plasma in der Nähe der Targetoberfläche stark in Richtung der Kathodenmitte gedrängt, d. h. eingeschnürt, wurde. Dies führte zu einer starken Impedanzerhöhung der Kathode, d. h. zu einer Schwächung des Plasmas bei gleicher Kathodenspannung.

Erst durch die erfindungsgemäße Maßnahme, das Permanent-Magnetsystem so auszulegen bzw. aus seiner Symmetrie zu "verstimmen", daß ohne Einschaltung der Magnetspule der Erosionsgraben in der Nähe des Außenrandes des Targets liegt, führt zu dem Erfolg des Erfindungsgegenstandes. Dann nämlich, wenn die Magnetspule eingeschaltet und mit dem entsprechend variierten Erregerstrom beschickt wird, so wird aufgrund der Nahwirkung des Feldes an der Targetoberfläche der Erosionsgraben in Richtung auf die Mitte des jeweiligen Targetquerschnitts verschoben, während die in größerer Ferne wirkende Komponente des elektromagnetischen Feldes die Plasmadichte in Substratnähe erhöht.

Die Erfindung bezieht sich darüber hinaus auch auf eine Magnetronkathode zur Durchführung des eingangs beschriebenen Kathodenzerstäubungsverfahrens.

Zur Lösung im wesentlichen der gleichen Aufgabe ist diese Magnetronkathode erfindungsgemäß dadurch gekennzeichnet, daß
a) das Permanentmagnetsystem in der Weise ausgelegt ist, daß derjenige Bereich des magnetischen Tunnels, in dem die Feldlinien wenigstens angenähert parallel zur Zerstäubungsoberfläche verlaufen, wie sie im Neuzustand des Targets vorliegt, in die Nähe des äußeren Targetrandes verlagert ist, wodurch in Abwesentheit weiterer Magnetfelder die ringförmige Zone maximaler Targeterosion in der Nähe des äußeren Targetrandes liegt, und daß
b) außerhalb des äußeren Pols eine ringförmig geschlossene, dem Pol geometrisch ähnliche und den Pol umgebende Magnetspule angeordnet ist, die an ein Steuergerät für die Erzeugung eines sich zeitlich verändernden weiteren Magnetfeldes angeschlossen ist, wobei das $teuergerät so ausgelegt ist, daß durch mindestens einen, von Null verschiedenen zeitlichen Mittelwert eines Erregerstromes ein Magnetfeld ausbildbar ist, durch das aufgrund der Polungsrichtung und der Überlagerung mit dem Magnetfeld des Permanentmagnetsystems die ringförmige Zone maximaler Targeterosion im wesentlichen in die Mitte zwischen den beiden Targeträndern verlagerbar ist, wobei ferner durch periodische Veränderung des Erregerstroms die Zone maximaler Targeterosion periodisch aus der Mittellage nach beiden Seiten verlagerbar ist.

Die Verstimmung des Permanentmagnetsystems kann dabei auf unterschiedliche Art und Weise erfolgen:
1. Es kann der Polabstand "a" des inneren Pols vom Innenrand des Targets größer gewählt werden als der Polabstand "b" des äußeren Pols vom Außenrand des Targets, wobei die Polabstände auf untereinander parallele Ebene bezogen sind, die im Neuzustand des Targets durch die Pole und die Targetränder verlaufen.
2. Alternativ ist es möglich, die Remanenz bzw. Polfeldstärke des inneren Pols aufgrund entsprechender Auswahl des Magnetwerkstoffs kleiner zu wählen als die Remanenz des äußeren Pols.
3. Es ist möglich, die Polfläche des inneren Pols kleiner zu gestalten als die Polfläche des äußeren Pols.

Diese Maßnahmen können entweder einzeln oder in beliebigen Kombinationen und Unterkombinationen angewandt werden.

Besondere Bedeutung kommt dabei auch der Konstruktion der Magnetspule zu. Es ist zwar denkbar, die erforderlichen Amperewindungen durch eine Vielzahl von Windungen eines dünnen Kupferdrahtes zu erzeugen, jedoch ist es hierbei schwierig, eine ausreichende Kühlung herbeizuführen, da eine Kühlung durch Konvektion im Vakuum ausscheidet und ein Wärmeverlust durch Abstrahlung wegen der geringen zulässigen Temperaturdifferenzen aus praktischen Gründen gleichfalls vernachlässigbar ist. Der Einbau von Kühlkörpern in eine solche Spule würde einen erheblichen konstruktiven Aufwand mit sich bringen.

Es ist daher gemäß einer weiteren Ausgestaltung der Erfindung besonders vorteilhaft, wenn die Magnetspule aus 4 bis 20 Windungen, vorzugsweise aus 5 bis 10 Windungen, eines Rohres besteht, das aus gut strom- und wärmeleitendem Werkstoff besteht und an eine Kühlmittelquelle angeschlossen ist. Eine solche Spule läßt sich mit einem hohen Strom beaufschlagen und ist dennoch gut zu kühlen.

Um dieses Kühlsystem auch bei großen bzw. langen Rechteckkathoden verwirklichen zu können, werden zweckmäßig die einzelnen Windungen strömungsmäßig (aber nicht elektrisch) unterbrochen, und es werden die einzelnen Spulenabschnitte strömungstechnisch in Parallelschaltung betrieben, während für den Erregerstrom die Reihenschaltung beibehalten wird. Auf diese Weise wird ein allzu großer Strömungswiderstand vermieden.

Weitere Ausgestaltungen des Erfindungsgegenstandes ergeben sich aus den übrigen Unteransprüchen.

Zwei Ausführungsbeispiele des Erfindungsgegenstandes und deren Wirkungsweise werden nachfolgend anhand der Figuren 1 bis 4 näher erläutert.

Es zeigen:
- Figur 1: einen Axialschnitt durch eine weitgehend rotationssymmetrische Magnetronkathode,
- Figur 2: einen Teilausschnitt in Figur 1 in vergrößertem Maßstab, jedoch mit einem unterschiedlich ausgebildeten Target,
- Figur 3: einen Ausschnitt aus einer Seitenansicht der Magnetronkathode mit Magnetspule und
- Figur 4: ein Diagramm, in dem unterschiedliche Kurvenverläufe der Erregerströme für die Magnetspule dargestellt sind.

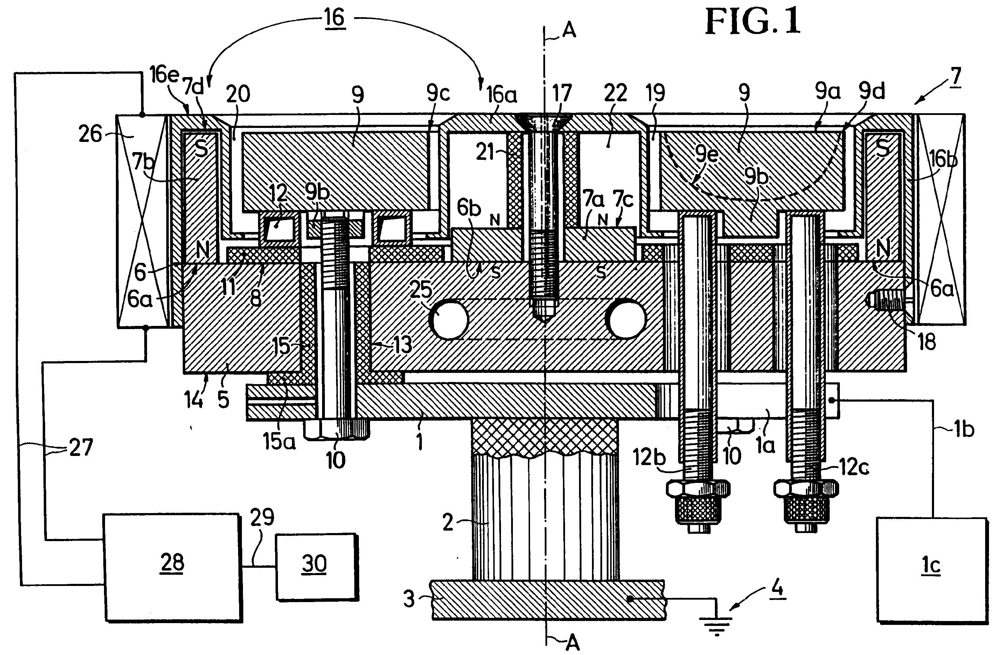

In Figur 1 ist eine Stromzuführungsplatte 1 dargestellt, die über einen Stützisolator 2 mit einer Vakuumkammer 3 verbunden ist, die ihrerseits an Masse 4 liegt. Die Stromzuführungsplatte besitzt eine radiale Ausnehmung 1a, auf die weiter unten noch eingegangen wird, und ist über eine Leitung 1b mit einer Stromquelle 1c verbunden, die die erforderliche Zerstäubungsspannung bzw. den Kathodenstrom liefert.

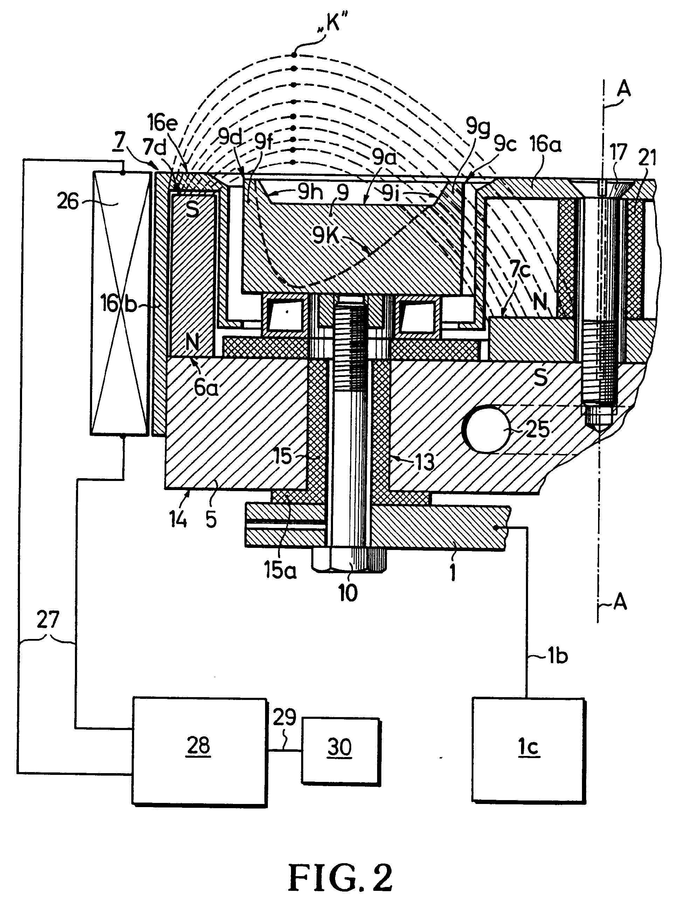

Mit der Stromzuführungsplatte 1 ist ein Magnetjoch 5 isoliert, aber fest verbunden, das im wesentlich gleichfalls plattenförmig ausgebildet ist. Das Magnetjoch besitzt auf seiner Oberseite eine ebene Fläche 6, in der ringförmig geschlossene Auflageflächen 6a und 6b für ein Permanentmagnetsystem 7 liegen. Dieses Permanentmagnetsystem 7 besteht aus einem inneren Ringmagneten 7a und einer geschlossenen äußeren Reihe von Stabmagneten 7b, die sämtlich in bezug auf die Achse A-A des Systems axial magnetisiert sind, und zwar derart, daß die Polungsrichtung des inneren Ringmagneten 7a umgekehrt zu derjenigen der äußeren Stabmagneten 7b verläuft. Die Pollage ist in Figur 1 ausdrücklich eingezeichnet. Das Permanentmagnetsystem 7 besitzt auf der dem Magnetjoch 5 abgekehrten Seite durch Polflächen gebildete Pole 7c und 7d, die in unterschiedlichen Ebenen liegen, und zwar ist die Ebene durch den Pol 7c gegenüber der Vorderseite der Magnetronkathode deutlich weiter zurückgesetzt als die Ebene durch den Pol 7d. Die Auswirkungen dieser Maßnahme werden anhand von Figur 2 noch näher erläutert.

Zwischen den Auflageflächen 6a und 6b bzw. zwischen den Polen 7c und 7d liegt eine ringförmig geschlossene Auflagefläche 8, oberhalb welcher ein ringförmiger Isolierkörper 11 und ein ringförmiges Target 9 mit einer ebenen Zerstäubungsfläche 9a angeordnet sind. Es ist möglich, durch entsprechende Wahl der Dicke des Isolierkörpers 11 die Zerstäubungsfläche 9a in Tiefenrichtung der Kathode in eine bestimmte räumliche Lage zu den Polen 7c und 7d zu bringen. Die Rückseite des Targets 9 ist mit einer umlaufenden Rippe 9b versehen, in die, auf dem Umfang verteilt, Gewinde für mehrere Zugschrauben 10 eingeschnitten sind. Durch diese Zugschrauben läßt sich das Target 9 gegen das Magnetjoch 5 und die Stromzuführungsplatte 1 verspannen; außerdem dienen die Zugschrauben 10 zur Übertragung des Kathodenstroms.

Zwischen dem Target 9 und dem Isolierkörper 11 befindet sich ein Targetkühlsystem 12, das aus einem entsprechend gewundenem Rohr mit rechteckigem Querschnitt besteht. Die beiden Enden 12b und 12c sind mit ausreichenden Isolierabständen durch nicht näher bezeichnete Bohrungen im Magnetjoch 5 bzw. durch die radiale Ausnehmung 1a in der Stromzuführungsplatte 1 hindurchgeführt. Beim Anziehen der Zugschrauben 10 stützt sich das Target 9 auf dem Targetkühlsystem 12 und dieses auf dem Isolierkörper 11 ab.

Wie aus Figur 1 ersichtlich, verläuft von der ebenen Fläche 6 eine Bohrung 13 bis zur gegenüberliegenden ebenen Fläche 14 des Magnetjochs 5. Die in Figur 1 dargestellte Bohrung 13 steht stellvertretend für eine Vielzahl solcher Bohrungen, durch die jeweils eine Zugschraube 10 hindurchgeführt ist.

In der Bohrung 13 ist ein hülsenförmiger Isolierkörper 15 angeordnet, der außerhalb der Bohrung 13 einen auf der ebenen Fläche 14 aufliegenden Kragen 15a besitzt. Auf diesem Kragen stützt sich die Stromzuführungsplatte 1 unter der Kraft der Zugschrauben 10 ab.

Es ist erkennbar, daß auf diese Weise die Stromführungsplatte 1 mit dem Target 9 sowohl gegenüber dem Magnetjoch 5 mit der Magnetanordnung 7 als auch gegenüber der Vakuumkammer 3 bzw. der Masse 4 elektrisch isoliert sind. Während das Target 9 über die Stromführungsplatte 1 auf ein definiertes negatives Potential gebracht werden kann und auch die Masse 4 ein definiertes Potential (Null-Potential) darstellt, ist das Magnetsystem 7 mit dem Magnetjoch 5 elektrisch unabhängig und kann sich auf ein durch die Betriebsbedingungen vorgegebenes Zwischenpotential einstellen, so daß eine Zerstäubung des Magnetsystems unterbleibt. Man nennt ein solches Potential auch ein "floatendes Potential". Ein Kühlkanal 25 im Magnetjoch 5 dient zur Wärmeabfuhr.

Das Magnetsystem 7 ist in einem Gehäuse 16 untergebracht, das aus einem nichtferromagnetischen Werkstoff besteht. Das Gehäuse 16 besteht aus zwei rotationssymmetrischen Teilen, nämlich aus einem topfförmigen zentralen Gehäuseteil 16a, das den Ringmagneten 7a einschließt und mittels einer Schraube 17 mit dem Magnetjoch 5 verspannt ist, sowie aus einem ringförmigen äußeren Gehäuseteil 16b, welches - im Querschnitt gesehen - die Stabmagnete 7b in einer endlosen, d. h. geschlossenen Reihe umschließt und mittels mehrerer Schrauben 18, von denen nur eine gezeigt ist, gleichfalls mit dem Magnetjoch 5 verschraubt ist. Das Gehäuse 16 besitzt eine Stirnseite 16e, die aus einer Kreisfläche (des Gehäuseteils 16a) und einer hierzu konzentrischen Kreisringfläche (des Gehäuseteils 16b) besteht. Ausgehend von dieser Stirnseite 16e ist das Gehäuse 16 hinter das Target 9 eingezogen ausgebildet.

Es ist aus Figur 1 weiterhin zu entnehmen, daß die beiden Gehäuseteile 16a und 16b von der Stirnseite 16e ausgehend die Magnete 7a und 7b bzw. deren Pole 7c und 7d übergreifen und in Form zweier zylindrischer Zargen die zylindrische Innenfläche und die zylindrische Außenfläche des Targets 9 unter Belassung der beiden hohlzylindrischen Luftspalte 19 und 20 übergreifen.

Während der Pol 7d nahezu an die Rückseite der Stirnseite 16e des Gehäuses anstößt, wird zwischen dem Pol 7c und der Rückseite der Stirnseite 16e des Gehäuses ein Raum 22 gebildet, durch den die Schraube 17 hindurchgeführt ist, die von einer Isolierstoffhülse 21 umgeben ist. Das restliche Volumen des Hohlraums kann allerdings auch durch Füllstücke aus nichtferromagnetischem Werkstoff ausgefüllt werden.

Figur 1 ist schließlich noch folgendes zu entnehmen:

Das Target 9 besitzt einen Innenrand 9c und einen Außenrand 9d, die zwischen sich die Zerstäubungsfläche 9a einschließen. Diese Zerstäubungsfläche ist im Neuzustand des Targets eben ausgebildet, verlagert sich jedoch mit zunehmendem Verbrauch des Targetmaterials in Richtung der gestrichelten Linie 9e. Der solchermaßen verbrauchte Teil des Targets 9 wird auch als "Erosionsgraben" bezeichnet.

Der Pol 7c liegt innerhalb des Innenrandes 9c, und der Pol 7d liegt außerhalb des Außenrandes 9d, so daß sich in der Projektion auf die Auflagefläche 8 die Pole 7c bzw. 7d und das Target 9 nicht überschneiden, zumal noch die Luftspalte 19 und 20 und die Zargen des Gehäuses 16 zwischengeschaltet sind.

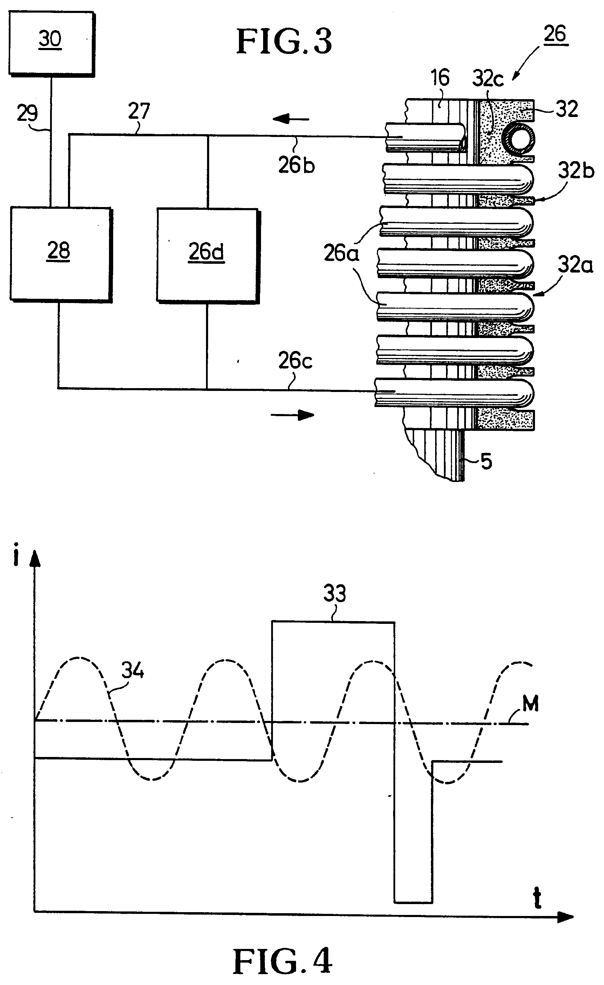

Die äußere Zylinderfläche des Gehäuses 16 ist von einer Magnetspule 26 umgeben, die anhand von Figur 3 noch näher erläutert werden wird. Bei dieser Magnetspule handelt es sich im vorliegenden Falle um eine Zylinderspule, die die Magnetronkathode auf einem wesentlichen Teil ihrer axialen Erstreckung umgibt. Die Magnetspule 26 ist über eine Leitung 27 mit einer Stromquelle 28 verbunden, der über eine Leitung 29 ein Steuergerät 30 aufgeschaltet ist. Dieses Steuergerät 30 erzeugt variable Ausgangsspannungen, wie sie anhand von Figur 4 noch näher erläutert werden. Die einzelnen Spannungsverläufe sind einstellbar.

Das Steuergerät 30 ist dabei so ausgelegt, daß durch einen von Null verschiedenen zeitlichen Mittelwert eines Erregerstromes und durch die Magnetspule 26 ein Magnetfeld ausgebildet wird, durch das aufgrund der Polungsrichtung und der Überlagerung mit dem Magnetfeld des Permanentmagnetsystems die ringförmige Zone maximaler Targeterosion in die Mitte zwischen den beiden Targeträndern 9c und 9d verlagert wird. Ferner wird durch die periodische Veränderung des Erregerstroms gemäß Figur 4 die Zone maximaler Targeterosion periodisch aus der Mittellage nach beiden Seiten verlagert, wobei die Verweilzeiten dieser Verlagerung und die Verlagerungsgeschwindigkeit durchaus Ausprobieren gefunden werden können.

In Figur 2 sind gleiche Teile wie in Figur 1 mit gleichen Bezugszeichen versehen. In diesem Fall ist jedoch die Zerstäubungsfläche 9a auf beiden Seiten (im Querschnitt gesehen) von Ringwülsten 9f und 9g umgeben, die zur Zerstäubungsfläche 9a hin schräge Böschungsflächen 9h und 9i aufweisen. Der Böschungswinkel hat den Vorteil, daß sich am Innenrand der Ringwülste kein Material niederschlägt, daß nach einiger Zeit abbröckelt und Substrate und/oder das Target kontaminiert.

In Figur 2 sind auch die Verläufe von magnetischen Feldlinien eingetragen, die sich zwischen den Polflächen der Pole 7c und 7d erstrecken. Es ist erkennbar, daß sich die Kulminationspunkte "K" der Feldlinien durch die Tiefenstaffelung der Polflächen nach links, d. h. in Richtung auf den Außenrand 9d verschoben haben. Solange die Magnetspule 26 nicht vom Erregerstrom durchflossen wird, entsteht die maximale Intensität des Plasmas unterhalb dieser Kulminationspunkte, so daß an dieser Stelle auch ein Erosionsgraben gebildet würde, dessen Querschnitt durch die gestrichelte Linie 9k angedeutet ist. Durch das Zuschalten der Magnetspule 26 mit entsprechender Variation des Erregerstroms gemäß Figur 4 wird nun erreicht, daß der Erosionsgraben einen Verlauf gemäß der Linie 9e in Figur 1 erhält.

Figur 3 zeigt nun Einzelheiten der Magnetspule 26, die aus insgesamt sieben Windungen 26a eines Kupferrohres besteht, das um das Gehäuse 16 herumgewickelt ist. Zum Zwecke der Einhaltung entsprechender Isolationsabstände sind in Abständen auf dem Gehäuse 16 Isolatoren 32 befestigt, von denen in Figur 3 nur einer dargestellt ist. Dieser Isolator hat die Form eines Quaders, dessen eine Langseite mit Einkerbungen 32a versehen ist, die dem Durchmesser des Rohres entsprechen. Die dazwischen angeordneten Stege 32b und 32c gewährleisten den erforderlichen Isolationsabstand. Die Rohrenden sind über Kühlmittelleitungen 26b und 26c mit einer Kühlmittelquelle 26d verbunden, die in der einfachsten Form als Wärmetauscher ausgebildet sein kann.

Bei dem Diagramm nach Figur 4 ist auf der Abszisse die Zeit t und auf der Ordinate der Erregerstrom i aufgetragen, jeweils in dimensionslosen Einheiten.

Die Kurve 33 zeigt einen Stromverlauf, der einen von Null verschiedenen zeitlichen Mittelwert M besitzt. Bei Einhaltung dieses Mittelwerts würde die Zone maximaler Targeterosion ziemlich genau in der Mitte zwischen den Targeträndern 9c und 9d entstehen, d. h. wenn der Erregerstrom nicht variiert würde. Durch Variation nach oben und nach unten wird jedoch die Zone maximaler Targeterosion von der Mitte ausgehend nach beiden Seiten verlagert, so daß der Erosionsgraben gemäß der gestrichelten Linie 9e in Figur 1 entsteht. Die zeitlichen Anteile für positive oder negative Abweichungen von dem Mittelwert M können, wie bereits gesagt, durch Versuche bestimmt werden. Unter Umständen genügen bereits sehr kurze Verweilzeiten des Plasmas an jedem Ende des Hubes, um etwa auf der Zerstäubungsfläche gebildete Reaktionsprodukte abzustäuben.

Die gestrichelte Kurve 34 zeigt eine andere Möglichkeit der Variation des Erregerstromes: In diesem Fall führt der Erregerstrom einen sinusförmigen Verlauf aus, jedoch nicht um die Null-Linie (wie beim Stand der Technik), sondern um den besagten Mittelwert M.

Das Substrat ist in den Figuren nicht gezeigt: Es liegt der Zerstäubungsfläche 9a im Abstand einiger Zentimeter gegenüber. Falls es sich um ein oder mehrere Substrate mit ebenen Beschichtungsflächen handelt, verlaufen diese bzw. ihr Transportweg parallel zur Zerstäubungsfläche.

Die Magnetronkathode kann gegenüber Figur 1 auch in Überkopflage montiert und betrieben werden.

## Patentansprüche

1. Verfahren zum Beschichten von Substraten durch Kathodenzerstäubung unter Verwendung einer Magnetronkathode mit einem ringförmig geschlossenen Target mit einer Zerstäubungsfläche, einem Innenrand und einem Außenrand und mit einem Permanentmagnete enthaltenden Magnetsystem, dessen einer, dem Target geometrisch ähnlicher, Pol außerhalb des Außenrandes und dessen anderer geometrisch ähnlicher und gleichfalls ringförmig geschlossener Pol innerhalb des Innenrandes angeordnet ist, derart, daß zumindest der überwiegende Teil der magnetischen Feldlinien auf nur wenig gekrümmten Bahnen in der Weise über die Zerstäubungsfläche hinweggeführt wird, daß ein ringförmiger, über der Zerstäubungsfläche geschlossener magnetischer Tunnel gebildet wird, wobei sich das Magnetsystem sowohl gegenüber Erdpotential als auch gegenüber Kathodenpotential auf einem sich selbst einstellenden elektrischen Potential befindet, **dadurch gekennzeichnet**, daß
a) derjenige Bereich des magnetischen Tunnels, in dem die Feldlinien wenigstens angenähert parallel zur Zerstäubungsfläche verlaufen, wie sie im Neuzustand des Targets vorliegt, durch entsprechende Auslegung des Permanentmagnetsystems in die Nähe des äußeren Targetrandes verlagert wird, wodurch in Abwesenheit weiterer Magnetfelder die ringförmige Zone maximaler Targeterosion in die Nähe des äußeren Targetrandes verlagert wird,
b) außerhalb des äußeren Pols mittels einer ringförmig geschlossen, dem Pol geometrisch ähnlichen und den Pol umgebenden Magnetspule ein sich zeitlich veränderndes weiteres Magnetfeld erzeugt wird, wobei durch mindestens einen von Null verschiedenen zeitlichen Mittelwert eines Erregerstroms ein Magnetfeld ausgebildet wird, durch das aufgrund der Polungsrichtung und der Überlagerung mit dem Magnetfeld des Permanentmagnetsystems die ringförmige Zone maximaler Targeterosion im wesentlichen in die Mitte zwischen den beiden Targeträndern verlagert wird, und daß
c) durch periodische Veränderung des Erregerstroms die Zone maximaler Targeterosion periodisch aus der Mittellage nach beiden Seiten verlagert wird.

2. Verfahren nach Anspruch 1, **dadurch gekennzeichnet,** daß für die Magnetspule pro Zentimeter der Spulenlänge zwischen 100 und 1000 Amperewindungen gewählt werden.

3. Magnetronkathode zum Beschichten von Substraten durch das Kathodenzerstäubungsverfahren nach Anspruch 1 mit einem ringförmig geschlossenen Target (9) mit einer Zerstäubungsfläche (9a), einem Innenrand (9c) und einem Außenrand (9d) und mit einem Permanentmagnete (7a, 7b) enthaltenden Magnetsystem (7), dessen einer, dem Target geometrisch ähnlicher, Pol (7d) außerhalb des Außenrandes und dessen anderer geometrisch ähnlicher und gleichfalls ringförmig geschlossener Pol (7c) innerhalb des Innenrandes angeordnet ist, derart, daß zumindest der überwiegende Teil der magnetischen Feldlinien auf nur wenig gekrümmten Bahnen in der Weise über die Zerstäubungsfläche hinweggeführt ist, daß ein ringförmiger, über der Zerstäubungsfläche geschlossener magnetischer Tunnel vorhanden ist, wobei das Magnetsystem sowohl gegenüber Erdpotential als auch gegenüber Kathodenpotential isoliert ist, **dadurch gekennzeichnet,** daß
a) das Permanentmagnetsystem (7) in der Weise ausgelegt ist, daß derjenige Bereich des magnetischen Tunnels, in dem die Feldlinien wenigstens angenähert parallel zur Zerstäubungsfläche (9a) verlaufen, wie sie im Neuzustand des Targets (9) vorliegt, in die Nähe des äußeren Targetrandes (9d) verlagert ist, wodurch in Abwesenheit weiterer Magnetfelder die ringförmige Zone maximaler Targeterosion in der Nähe des äußeren Targetrandes liegt, und daß
b) außerhalb des äußeren Pols (7d) eine ringförmig geschlossene, dem Pol geometrisch ähnliche und den Pol umgebende Magnetspule (26) angeordnet ist, die an ein Steuergerät (30) für die Erzeugung eines sich zeitlich verändernden weiteren Magnetfeldes angeschlossen ist, wobei das Steuergerät so ausgelegt ist, daß durch einen von Null verschiedenen zeitlichen Mittelwert eines Erregerstromes ein Magnetfeld ausbildbar ist, durch das aufgrund der Polungsrichtung und der Überlagerung mit dem Magnetfeld des Permanentmagnetsystems (7) die ringförmige Zone maximaler Targeterosion im wesentlichen in die Mitte zwischen den beiden Targeträndern (9c, 9b) verlagerbar ist, wobei ferner durch periodische Veränderung des Erregerstroms die Zone maximaler Targeterosion periodisch aus der Mittellage nach beiden Seiten verlagerbar ist.

4. Magnetronkathode nach Anspruch 3, **dadurch gekennzeichnet,** daß für die Magnetspule pro Zentimeter Länge des Spulenumfangs zwischen 100 und 1000 Amperewindungen vorhanden sind.

5. Magnetronkathode nach Anspruch 3, **dadurch gekennzeichnet,** daß der Polabstand "a" des inneren Pols (7c) vom Innenrand (9c) des Targets (9) größer ist als der Polabstand "b" des äußeren Pols (7d) vom Außenrand (9d) des Targets (9), wobei die Polabstände auf untereinander parallele Ebenen bezogen sind, die im Neuzustand des Targets (9) durch die Pole und die Targetränder verlaufen.

6. Magnetronkathode nach Anspruch 3, **dadurch gekennzeichnet,** daß die Remanenz des inneren Pols (7c) aufgrund entsprechender Auswahl des Magnetwerkstoffs kleiner ist als die Remanenz des äußeren Pols (7d).

7. Magnetronkathode nach Anspruch 3, **dadurch gekennzeichnet,** daß die Polfläche des inneren Pols (7c) kleiner ist als die Polfläche des äußeren Pols (7d).

8. Magnetronkathode nach Anspruch 3, **dadurch gekennzeichnet,** daß die Magnetspule (26) aus 4 bis 20 Windungen, vorzugsweise 5 bis 10 Windungen, eines Rohres besteht, das aus gut strom- und wärmeleitendem Werkstoff besteht und an eine Kühlmittelquelle (27) angeschlossen ist.

## Claims

1. Process for coating substrates by cathodic sputtering using a magnetron cathode with an annularly enclosed target with a sputtering surface, an inner edge and an outer edge and with a magnet system containing permanent magnets, one pole of which, geometrically similar to the target, is arranged outside the outer edge and the other pole of which, geometrically similar and also annularly enclosed, is arranged inside the inner edge, in such a way that at least the majority of the magnetic field lines are guided away over the sputtering surface on only slightly curved paths in such a way that an annular magnetic tunnel enclosed over the sputtering surface is formed, the magnet system being at a self-setting electrical potential both with respect to earth potential and with respect to cathode potential, characterized in that
a) that area of the magnetic tunnel, in which the field lines run at least approximately parallel to the sputtering surface, as present in the new state of the target, is displaced into the vicinity of the outer target edge by means of corresponding design of the permanent magnet system, the annular zone of maximum target erosion being displaced into the vicinity of the outer target edge in the absence of further magnetic fields,
b) a further magnetic field which changes over time is created outside the outer pole by means of an annularly enclosed magnetic coil geometrically similar to the pole and surrounding the pole, a magnetic field being formed by at least one time-wise mean value of an energizing current different from zero, by means of which magnetic field the annular zone of maximum target erosion is essentially displaced into the centre between the two target edges on the basis of the direction of polarity and the superposition with the magnetic field of the permanent magnet system, and that
c) the zone of maximum target erosion is periodically displaced from the centre position towards both sides by periodic changing of the energizing current.

2. Process according to Claim 1, characterized in that between 100 and 1000 ampere-turns are selected for the magnetic coil per centimetre of the coil length.

3. Magnetron cathode for coating substrates by means of the cathodic sputtering process according to Claim 1 with an annularly enclosed target (9) with a sputtering surface (9a), an inner edge (9c) and an outer edge (9d) and with a magnet system (7) containing permanent magnets (7a, 7b), one pole (7d) of which, geometrically similar to the target, is arranged outside the outer edge and the other pole (7c) of which, geometrically similar and also annularly enclosed, is arranged inside the inner edge, in such a way that at least the majority of the magnetic field lines are guided away over the sputtering surface on only slightly curved paths in such a way that an annular magnetic tunnel enclosed over the sputtering surface is present, the magnet system being isolated both with respect to earth potential and with respect to cathode potential, characterized in that
a) the permanent magnet system (7) is designed in such a way that that area of the magnetic tunnel, in which the field lines run at least approximately parallel to the sputtering surface (9a), as present in the new state of the target (9), is displaced into the vicinity of the outer target edge (9d), the annular zone of maximum target erosion lying in the vicinity of the outer target edge in the absence of further magnetic fields, and that
b) an annularly enclosed magnetic coil (26) geometrically similar to the pole and surrounding the pole is arranged outside the outer pole (7d) which coil is connected to a control unit (30) for the creation of a further magnetic field changing over time, the control unit being designed in such a way that a magnetic field can be formed by mean of a time-wise mean value of an energizing current different from zero, by means of which magnetic field the annular zone of maximum target erosion can be essentially displaced into the centre between the two target edges (9c, 9b) on the basis of the direction of polarity and the superposition with the magnetic field of the permanent magnet system (7), the zone of maximum target erosion also being periodically displaceable from the centre position towards both sides by periodic changing of the energizing current.

4. Magnetron cathode according to Claim 3, characterized in that between 100 and 1000 ampere-turns are present for the magnetic coil per centimetre length of the coil circumference.

5. Magnetron cathode according to Claim 3, characterized in that the polar distance "a" between the inner pole (7c) and the inner edge (9c) of the target (9) is greater than the polar distance "b" between the outer pole (7d) and the outer edge (9d) of the target (9), the polar distances being related to planes that are parallel to one another and which run through the poles and the target edges in the new state of the target (9).

6. Magnetron cathode according to Claim 3, characterized in that the remanence of the inner pole (7c) is smaller than the remanence of the outer pole (7d) on the basis of corresponding selection of the magnet material.

7. Magnetron cathode according to Claim 3, characterized in that the pole face of the inner pole (7c) is smaller than the pole face of the outer pole (7d).

8. Magnetron cathode according to Claim 3, characterized in that the magnetic coil (26) comprises four to 20 turns, preferably five to 10 turns, of a tube which comprises a material which is a good conductor of heat and of electricity and which is connected to a coolant source (27).

## Revendications

1. Procédé pour recouvrir des substrats par pulvérisation cathodique en utilisant une cathode magnétron comprenant une cible fermée annulaire présentant une surface de pulvérisation, un bord intérieur et un bord extérieur et comprenant un système magnétique contenant un aimant permanent, dont un pôle géométriquement semblable à la cible est disposé à l'extérieur du bord extérieur et dont l'autre pôle géométriquement semblable et également fermé et annulaire est disposé à l'intérieur du bord intérieur, de sorte qu'au moins la partie prépondérante des lignes de champ magnétique passe sur des trajectoires seulement peu courbées au-dessus de la surface de pulvérisation, de telle sorte qu'un tunnel magnétique annulaire, fermé au-dessus de la surface de pulvérisation, est formé, le système magnétique se trouvant à un potentiel électrique s'installant lui-même aussi bien par rapport au potentiel terrestre que par rapport au potentiel de cathode, caractérisé en ce que
a) le domaine du tunnel magnétique dans lequel les lignes de champ au moins de façon approchée, sont parallèles à la surface de pulvérisation telle qu'elle se présente à l'état neuf de la cible, est déplacé au voisinage du bord extérieur de la cible par l'intermédiaire d'un dimensionnement correspondant du système magnétique permanent, la zone annulaire d'érosion maximale de cible étant ainsi, en l'absence d'autres champs magnétiques, déplacée au voisinage du bord extérieur de la cible,
b) un autre champ magnétique se modifiant au cours du temps est produit à l'extérieur du pôle extérieur à l'aide d'une bobine électromagnétique annulaire fermée entourant le pôle et géométriquement semblable au pôle, un champ magnétique étant formé par l'intermédiaire d'au moins une valeur moyenne temporelle différente de 0 d'un courant d'excitation, champ magnétique par l'intermédiaire duquel la zone annulaire d'érosion maximale de cible est globalement déplacée au milieu entre les deux bords de cible en raison de la direction de polarisation et de la superposition avec le champ magnétique du système magnétique permanent, et en ce que
c) la zone d'érosion maximale de cible est déplacée périodiquement depuis la position de milieu vers les deux côtés par modification périodique du courant d'excitation.

2. Procédé selon la revendication 1, caractérisé en ce qu'on choisit pour la bobine électromagnétique un nombre d'ampèretours par centimètre de longueur de bobine entre 100 et 1 000.

3. Cathode magnétron pour recouvrir des substrats par le procédé de pulvérisation cathodique selon la revendication 1, comprenant une cible fermée annulaire (9) présentant une surface de pulvérisation (9a), un bord intérieur (9c) et un bord extérieur (9d) et comprenant un système magnétique (7) contenant un aimant pemanent (7a, 7b), dont un pôle (7d) géométriquement semblable à la cible est disposé à l'extérieur du bord extérieur et dont l'autre pôle géométriquement semblable et également fermé et annulaire (7c) est disposé à l'intérieur du bord intérieur, de sorte qu'au moins la partie prépondérante des lignes de champ magnétique passe sur des trajectoires seulement peu courbées au-dessus de la surface de pulvérisation, de telle sorte qu'un tunnel magnétique annulaire, fermé au-dessus de la surface de pulvérisation, est formé, le système magnétique pouvant être isolé aussi bien par rapport au potentiel terrestre que par rapport au potentiel de cathode, caractérisée en ce que
a) le système magnétique permanent (7) est dimensionné de telle manière que le domaine du tunnel magnétique, dans lequel les lignes de champ, au moins de façon approchée sont parallèles à la surface de pulvérisation (9a), telle qu'elle se présente à l'état neuf de la cible (9), est déplacé au voisinage du bord extérieur de la cible (9d), la zone annulaire d'érosion maximale de cible se trouvant ainsi au voisinage du bord extérieur de la cible en l'absence d'autres champs magnétiques, et en ce que
b) à l'extérieur du pôle extérieur (7d) est disposée une bobine électromagnétique (26) fermée annulaire entourant le pôle et géométriquement semblable au pôle, qui est raccordée à un appareil de commande (30) pour la production d'un autre champ magnétique se modifiant temporellement, l'appareil de commande étant dimensionné de sorte qu'on peut former un champ magnétique par l'intermédiaire d'une valeur moyenne temporelle différente de 0 d'un courant d'excitation, champ magnétique par l'intermédiaire duquel on peut globalement déplacer la zone annulaire d'érosion maximale de cible au milieu entre les deux bords de cible (9c, 9b) en raison de la direction de polarisation et de la superposition avec le champ magnétique du système magnétique permanent (7), la zone d'érosion maximale de cible pouvant de plus être périodiquement déplacée de la position de milieu vers les deux côtés par modification périodique du courant d'excitation.

4. Cathode magnétron selon la revendication 3, caractérisée en ce que pour la bobine électromagnétique entre 100 et 1 000 ampèretours sont présents par centrimètre de longueur du périmètre de la bobine.

5. Cathode magnétron selon la revendication 3, caractérisée en ce que l'écartement polaire "a" du pôle intérieur (7c) à partir du bord intérieur (9c) de la cible (9) est plus grand que l'écartement polaire "b" du pôle extérieur (7d) à partir du bord extérieur (9d) de la cible (9), les écartements polaires étant rapportés aux surfaces parallèles entre elles, à l'état neuf de la cible (9), qui passent à travers les pôles et les bords de cible.

6. Cathode magnétron selon la revendication 3, caractérisée en ce que la rémanence du pôle intérieur (7c) est plus petite que la rémanence du pôle extérieur (7d) en raison du choix correspondant du matériau magnétique.

7. Cathode magnétron selon la revendication 3, caractérisée en ce que la surface de pôle du pôle intérieur (7c) est plus petite que la surface de pôle du pôle extérieur (7d).

8. Cathode magnétron selon la revendication 3, caractérisée en ce que la bobine électromagnétique (26) est constituée de 4 à 20 tours, de préférence de 5 à 10 tours d'un fil réalisé dans un bon matériau conducteur de courant et de chaleur et raccordé à une source d'agent de refroidissement (27).
